(19) **Europäisches Patentamt / European Patent Office / Office européen des brevets**

(11) **EP 3 350 611 B1**

(12) # EUROPEAN PATENT SPECIFICATION

(45) Date of publication and mention of the grant of the patent:
**04.11.2020 Bulletin 2020/45**

(51) Int Cl.:
*G01R 33/563* $^{(2006.01)}$     *G01N 24/08* $^{(2006.01)}$
*G01F 1/716* $^{(2006.01)}$     *G01V 3/14* $^{(2006.01)}$
*G01R 33/44* $^{(2006.01)}$

(21) Application number: **16753830.5**

(22) Date of filing: **16.08.2016**

(86) International application number:
**PCT/EP2016/025088**

(87) International publication number:
**WO 2017/045767 (23.03.2017 Gazette 2017/12)**

(54) **A NUCLEAR MAGNETIC RESONANCE FLOWMETER AND A METHOD OF MEASURING FLOW USING NUCLEAR MAGNETIC RESONANCE**

KERNSPINRESONANZDURCHFLUSSMESSER UND VERFAHREN ZUR MESSUNG DES DURCHFLUSSES MITHILFE VON KERNSPINRESONANZ

DÉBITMÈTRE À RÉSONANCE MAGNÉTIQUE NUCLÉAIRE ET PROCÉDÉ DE MESURE DE DÉBIT PAR RÉSONANCE MAGNÉTIQUE NUCLÉAIRE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **15.09.2015 GB 201516324**

(43) Date of publication of application:
**25.07.2018 Bulletin 2018/30**

(73) Proprietor: **Gill Corporate Limited New Milton, Hampshire BH25 6QJ (GB)**

(72) Inventors:
- **BACON, Robin**
  **Romsey**
  **Hampshire S051 7WB (GB)**
- **BIRTWELL, Samuel William**
  **Lymington**
  **Hampshire SO41 9DN (GB)**
- **GILL, Michael John**
  **Beaulieu**
  **Hampshire SO42 7XA (GB)**
- **BLACKLOCK, Oliver Stewart**
  **Lymington**
  **Hampshire SO41 9GT (GB)**

(74) Representative: **Crouch, David John et al Bromhead Johnson 57-59 High Street Twyford, Berkshire RG10 9AJ (GB)**

(56) References cited:
**US-A- 4 638 251**     **US-A1- 2011 001 474**
**US-A1- 2014 009 148**

- **FRIDJONSSON EINAR O ET AL: "Earth's field NMR flow meter: Preliminary quantitative measurem", JOURNAL OF MAGNETIC RESONANCE, ACADEMIC PRESS, ORLANDO, FL, US, vol. 245, 25 June 2014 (2014-06-25), pages 110-115, XP029015498, ISSN: 1090-7807, DOI: 10.1016/J.JMR.2014.06.004**
- **SHUSHAKOV O A: "GROUNDWATER NMR IN CONDUCTIVE WATER", GEOPHYSICS, SOCIETY OF EXPLORATION GEOPHYSICISTS, US, vol. 61, no. 4, 1 July 1996 (1996-07-01), pages 998-1006, XP000633871, ISSN: 0016-8033, DOI: 10.1190/1.1444048**
- **STEPISNIK J ET AL: "NMR IMAGING IN THE EARTH'S MAGNETIC FIELD", MAGNETIC RESONANCE IN MEDICINE, JOHN WILEY & SONS, INC, US, vol. 15, no. 3, 1 September 1990 (1990-09-01), pages 386-391, XP000170518, ISSN: 0740-3194**

## Description

The present invention relates to a nuclear magnetic resonance flowmeter and to a method of measuring flow using nuclear magnetic resonance.

One such flowmeter is described in US-A-4638251. This describes apparatus for measuring the flow of nonhomogeneous materials in an incompletely filled channel. The apparatus comprises a magnet forming the requisite magnetic field across the flow channel. The magnet co-operates with a coil providing an NMR output signal from selected species of subatomic particles in the material in the flow stream. A composition sensor coil inscribing a very small volume in selected portions of the flow channel is included to form an NMR output signal indicative of composition, the small volume being filled for that sensor. One problem with such a flowmeter is that it relies on a permanent magnet to generate the magnetic field required. This provides a problem with certain applications, for example in the case of measurement of the flow of water along a naturally formed river.

Fridjonsson, Einar O et al: "Earth's field NMR flow meter: Preliminary quantitative measurement", Journal of Magnetic Resonance, Academic Press, Orlando, FL, US, vol. 245, 25 June 2014 (2014-06-25), pages 110-115, XP029015498, ISSN: 1090-7807, DOI: 10.1016/J.JMR.2014.06.004 describes the use of Earth's field NMR (EF NMR) combined with a pre-polarising permanent magnet for measuring fast fluid velocities. NMR signal intensities are measured as a function of flow rate (0-1m/s) and separation distance between the permanent magnet and the EF NMR signal detection.

US2014/009148 A1 describes Nuclear Magnetic Resonance (NMR) measurement apparatus, sensors and measurement methods to determine NMR properties of engineered flow management structures, and to estimate engineering properties using determined NMR properties. Example engineered flow management structures include engineered water storage, water management, water production, water sampling structures, and/or structures that serve as conduits or barriers to water movement.

EP-A-0106472 describes a nuclear magnetic resonance method and apparatus in which a magnetic field is generated using coils through which are passed an electric current. However this method depends upon the creation of another magnetic field with a gradient. Whilst such an apparatus and method may be suitable for measuring the flow of fluid in a living body, they are less suitable for the measurement of flow for example in a naturally formed river.

WO-A-2009045670 describes a nuclear magnetic resonance method and apparatus for detection of a liquid under a surface, but this is a means of detection of static material rather than apparatus and a method for measuring flow.

The present invention seeks to address one or more of the foregoing shortcomings of such previously proposed nuclear magnetic resonance apparatus and methods.

Accordingly, the present invention is directed to a nuclear magnetic resonance flowmeter comprising at least one coil of electrically conductive material through which an electrical current flows when the apparatus is in use to generate a magnetic field in a region through which flows a fluid the flow of which is to be measured and throughout which there is a uniform weak magnetic field such as the Earth's magnetic field, electrical circuitry connected to the said at least one coil to switch on and abruptly switch off such an electrical current, an NMR sensor connected to the electrical circuitry to provide a measure of the decay in the NMR signal from nuclei within such fluid following the abrupt switching off of such an electrical current, and a processor of the electrical circuitry formed and/or programmed to provide a measure of the flow of such fluid from the said measure of the decay, characterised in that the said at least one coil by means of which the magnetic field is generated is sufficiently large to completely surround a river.

The said electrical current may be a direct current to generate a unidirectional magnetic field.

Alternatively, the said electrical current may be a pulsed or alternating current to generate a pulsed or alternating magnetic field.

The said NMR sensor may comprise the said at least one coil. This provides an economy of parts, and reduces the overall cost of production of the apparatus.

Alternatively, the said NMR sensor may comprise at least one other coil, in which case the NMR sensor does not comprise the said at least one coil. The latter may be located in substantially the same position as the said at least one coil.

The present invention extends to a method of measuring the flow of a fluid, in which an electrical current is passed through at least one coil of electrically conductive material to generate a magnetic field in a region through which flows fluid the flow of which is to be measured and throughout which there is a uniform weak magnetic field such as the Earth's magnetic field, and an electrical current is made to pass through the said at least one coil and is abruptly switched off, whereupon an NMR sensor is used to provide a measure of the decay of the NMR signal from precessing nuclei within such fluid following the abrupt switching off of the electrical current by an electrical circuitry connected to said at least one coil, and a measure of the flow of such fluid from the said measure of the decay is provided using a processor of the electrical circuitry, characterised in that the said at least one coil surrounds a river the flow of water along which is to be measured.

The NMR sensor may comprise the said at least one coil. Alternatively the NMR sensor may comprise at least one other coil.

Thus the foregoing method may be carried out using a flowmeter as described by one or more of the foregoing paragraphs setting out essential or optional features of the present invention.

An example of a nuclear magnetic resonance flowmeter embodying the present invention, and an example of a method of measuring the flow of a fluid using a nuclear magnetic resonance flowmeter embodying the present invention, will now be described in greater detail with reference to the accompanying drawings, in which:

Figure 1 shows an aerial diagrammatic view of a section of a river around which a part of apparatus made in accordance with the present invention is installed;

Figure 2 shows a cross section of the river and the part of the apparatus shown in Figure 1 in the plane indicated by the line II-II shown in Figure 1;

Figure 3 shows a longitudinal section of a river bank of the river shown in Figure 1, and the part of the apparatus shown in Figure 1, in the plane indicated by the line III-III in Figure 1;

Figure 4 shows electrical circuitry connected to that part of the apparatus shown in Figures 1 to 3; and Figures 5a, 5b, 5C and 5d are explanatory diagrams.

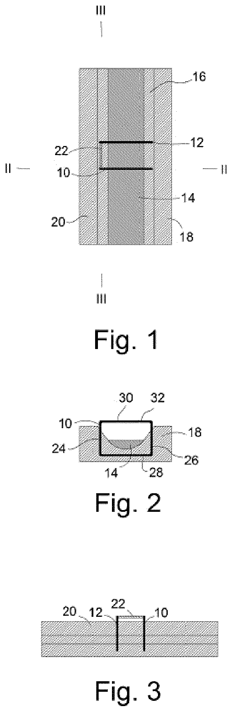

Two rectangular plastics frames 10 and 12 are shown in figures 1 to 3 both surrounding a river 14 which flows within a channel 16 defined between riverbanks 18 and 20. Each plastics frames 10 and 12 therefore extends transversely of the river 14. The two frames 10 and 12 are spaced apart and held together by a supporting strut 22, and are thereby located in substantially the same region of the river.

Each frame comprises two upright plastics tubes 24 and 26 respectively on opposite sides of the river 14, and two horizontal plastics tubes 28 and 30 connecting the lower ends and the upper ends of the upright tubes 24 and 26 respectively. The tubes 24, 26, 30 and 28 thereby create a continuous looped interior, providing a hard wearing housing for coils (not shown in Figures 1 to 3) which extend around the frame 10 within the interior thereof.

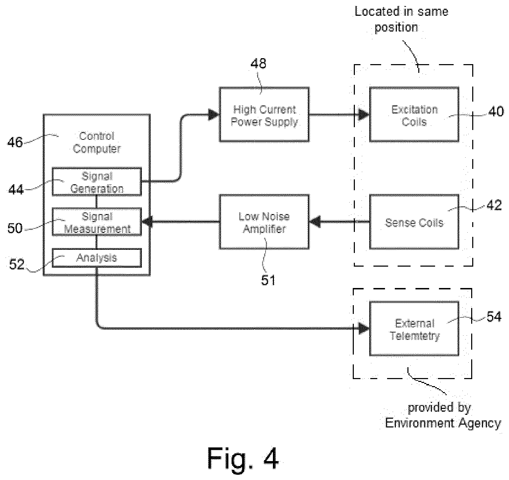

The frame 10 encloses excitation coils 40 (shown in Figure 4 but not shown in Figures 1 to 3), and the frame 12 encloses sense coils 42 (also shown in Figure 4 but not shown in Figures 1 to 3).

The excitation coils 40 are electrically connected to a signal generator 44 of a control processor or computer 46 via a high current power supply 48, and the sense coils 42 are connected to a signal measurement circuit 50 of the control computer 46 via a low noise amplifier 51.

The control computer 46 is also provided with an analysis unit 52 connected to an externally provided telemetry unit 54 provided by the environment agency of the territory within which flows the river 14.

The signal generator 44, the signal measurement circuit 50 and the analysis unit 52 of the control computer 46 are electrically interconnected.

The frames 10 and 12 together with the circuitry shown in Figure 4 (apart from the telemetry unit 54) constitute a nuclear magnetic resonance flowmeter.

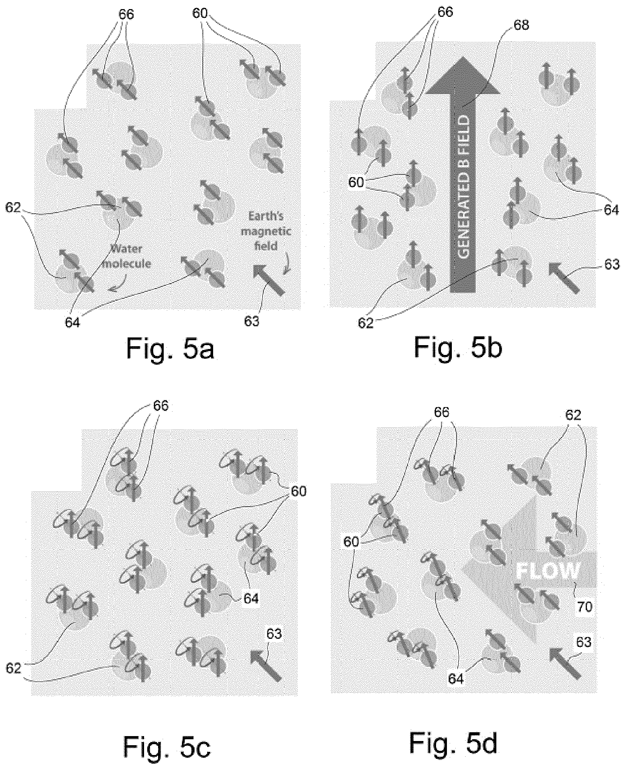

After a prolonged absence of any current flowing through the excitation coils 40, the nuclear magnetic moments of the hydrogen nuclei 60 of water molecules 62 in the river 14 in the region of the frames 10 and 12 are oriented in alignment with the Earth's magnetic field 63 as indicated by the arrows 66 in Figure 5a. In this regard it will be appreciated that the oxygen nuclei 64 of the water molecules 62 generally have a zero magnetic moment. The only naturally occurring oxygen nucleus that has a magnetic moment is $^{17}O$, and this is extremely rare.

When the circuitry shown in Figure 4 commences its operating cycle, a signal is generated by the signal generator 44 to cause the high current power supply 48 to switch on, so that a high electrical current is passed through the excitation coils 40 for a short amount of time. Because the strong magnetic field 68 generated as a result is generally horizontal, more or less in alignment with the river 14, this strong magnetic field 68 is at an angle to the Earth's magnetic field. As a consequence, the magnetic moments of the hydrogen nuclei 60 are aligned in parallel with this strong magnetic field 68, as shown by the arrows 66 in Figure 5b.

At this stage in the operating cycle of the circuitry shown in Figure 4, the high current power supply 48 is abruptly switched off by the signal generator 44 of the computer 46. This in turn abruptly removes the strong magnetic field 68 from the region of water in the river 20 adjacent to the coils 10 and 12. Consequently, in this region, the magnetic moments of the hydrogen nuclei 66 begin to precess around the direction of the Earth's magnetic field, as shown by the curled arrows in Figure 5c. Because of the uniformity of the Earth's magnetic field in the region concerned, all precession of the $^{1}H$ nuclei will be in phase. The frequency of this precession is the Larmour frequency for the $^{1}H$ nucleus within the Earth's magnetic field, being given by the equation:

$$\nu = \gamma B$$

in which ν is the Larmour frequency in MHz, $\gamma$ is the gyromagnetic ratio of the $^{1}H$ nucleus in MHz/Tesla, and B is the strength of the Earth's magnetic filed in Tesla.

The precessing of the hydrogen nuclei decays, during a transitional phase in which the magnetic moments of the $^{1}H$ nuclei are realigned with the Erath's magnetic field, over a period of about two seconds. At the same time, within the region of the coils 10 and 12, the flow 70 of water in the river displaces precessing nuclei by ones which are not precessing because they have not been subject to the intense magnetic field 68 generated by the coil 10. Therefore, the oscillating magnetic field signal picked up by the sensor coils 42 and relayed to the computer 46 decays for two reasons: (i) because of the reduction in the energy with which the nuclei are precessing, and (ii) because of the flow of water in the river 14. The former can be determined experimentally and stored in the control computer, to be processed by the signal measurement circuit 50 by subtracting from it the signal received from the sensor coils 42, to provide a measure of the flow of water in the river 14 by means of the analysis unit 52 of the control computer 46. Since the coils 40 and 42 encompass the whole of the river channel in the region, the flow measurement is for the river as a whole. The output from the analysis unit 52 is relayed to the external telemetry 54. By means of repetition of the operating cycle of the circuit shown in Figure 4, the external telemetry 54 is continually updated with the rate of flow of water along the river 14.

Numerous variations and modifications to the flowmeter illustrated in Figures 1 to 5 may occur to the reader without taking the resulting construction outside the scope of the present invention. For example, the sensor coil or coils 42 may be one and the same as the excitation coil or coils 40.

It will be appreciated that the electrical current passed through the excitation coil or coils 40 may be a direct current, to generate a unidirectional magnetic field, or it may be a pulsed or alternating current to generate a pulsed or alternating magnetic field, whether or not superimposed on a direct current to generate a pulsed or alternating magnetic field superimposed on a unidirectional magnetic field.

**Claims**

1. A nuclear magnetic resonance flowmeter comprising at least one coil (40) of electrically conductive material through which an electrical current flows when the apparatus is in use to generate a magnetic field in a region through which flows a fluid the flow of which is to be measured and throughout which there is a uniform weak magnetic field such as the Earth's magnetic field, electrical circuitry (46 to 52) connected to the said at least one coil (40) to switch on and abruptly switch off such an electrical current, NMR sensor (42) connected to the electrical circuitry (46 to 52) to provide a measure of the decay in the NMR signal from nuclei (60) within such fluid following the abrupt switching off of such an electrical current, and a processor (52) of the electrical circuitry formed and/or programmed to provide a measure of the flow of such fluid from the said measure of the decay, **characterised in that** the said at least one coil (40) by means of which the magnetic field is generated is sufficiently large to completely surround a river (14).

2. A nuclear magnetic resonance flowmeter according to claim 1, in which the said electrical current is a direct current to generate a unidirectional magnetic field.

3. A nuclear magnetic resonance flowmeter according to claim 1, in which the said electrical current is a pulsed or alternating current to generate a pulsed or alternating magnetic field.

4. A nuclear magnetic resonance flowmeter according to any preceding claim, in which the said NMR sensor (42) comprises the said at least one coil (40).

5. A nuclear magnetic resonance flowmeter according to any one of claims 1 to 3, in which the said NMR sensor (42) comprises at least one other coil (42), so that the NMR sensor 42 does not comprise the said at least one coil (40).

6. A nuclear magnetic resonance flowmeter according to claim 5, in which the said at least one other coil 42 is located in substantially the same position as the said at least one coil (40) .

7. A method of measuring the flow of a fluid, in which an electrical current is passed through at least one coil of electrically conductive material to generate a magnetic field in a region through which flows fluid the flow of which is to be measured and throughout which there is a uniform weak magnetic field such as the Earth's magnetic field, and an electrical current is made to pass through the said at least one coil (40) and is abruptly switched off by an electrical circuitry (46 to 52) connected to said at least one coil (40), whereupon an NMR sensor (42) is used to provide a measure of the decay of the NMR signal from precessing nuclei (60) within such fluid following the abrupt switching off of the electrical current (48), and a measure of the flow of such fluid from the said measure of the decay is provided using a processor (52) of the electrical circuitry, **characterised in that** the said at least one coil (40) surrounds a river (14) the flow of water along which is to be measured.

8. A method of measuring the flow of a fluid according to claim 7, using a flowmeter as claimed in any one of claims 2 to 6.

**Patentansprüche**

1. Kernmagnetresonanz-Durchflussmesser, umfassend mindestens eine Spule (40) aus elektrisch leitendem Material, durch die ein elektrischer Strom fließt, wenn die Vorrichtung in Verwendung ist, um ein Magnetfeld in einem Bereich zu erzeugen, durch den ein Fluid fließt, dessen Fluss zu messen ist, und in dem ein gleichförmiges schwaches Magnetfeld, wie das Magnetfeld der Erde, besteht, elektrische Schaltungen (46 bis 52), die mit der mindestens einen Spule (40) verbunden sind, um einen solchen elektrischen Strom ein- und plötzlich auszuschalten, einen NMR-Sensor (42), der mit den elektrischen Schaltungen (46 bis 52) verbunden ist, um ein Maß des Abklingens in dem NMR-Signal von Kernen (60) innerhalb eines solchen Fluids im Anschluss an das plötzliche Abschalten eines solchen elektrischen Stroms bereitzustellen, und einen Prozessor (52) der elektrischen Schaltungen, der gebildet und/oder programmiert ist, um ein Maß des Flusses eines solchen Fluids aus dem Maß des Abklingens bereitzustellen, **dadurch gekennzeichnet, dass** die mindestens eine Spule (40), mittels der das Magnetfeld erzeugt wird, ausreichend groß ist, um einen Wasserlauf (14) vollständig zu umgeben.

2. Kernmagnetresonanz-Durchflussmesser nach Anspruch 1, wobei der elektrische Strom ein Gleichstrom zum Erzeugen eines unidirektionalen Magnetfelds ist.

3. Kernmagnetresonanz-Durchflussmesser nach Anspruch 1, wobei der elektrische Strom ein gepulster oder Wechselstrom ist, um ein magnetisches gepulstes oder Wechselfeld zu erzeugen.

4. Kernmagnetresonanz-Durchflussmesser nach einem der vorstehenden Ansprüche, wobei der NMR-Sensor (42) die mindestens eine Spule (40) umfasst.

5. Kernmagnetresonanz-Durchflussmesser nach einem der Ansprüche 1 bis 3, wobei der NMR-Sensor (42) mindestens eine andere Spule (42) umfasst, so dass der NMR-Sensor (42) die mindestens eine Spule (40) nicht umfasst.

6. Kernmagnetresonanz-Durchflussmesser nach Anspruch 5, wobei die mindestens eine andere Spule (42) im Wesentlichen in derselben Position wie die mindestens eine Spule (40) liegt.

7. Verfahren zum Messen des Flusses eines Fluids, bei dem ein elektrischer Strom durch mindestens eine Spule aus elektrisch leitendem Material geführt wird, um ein Magnetfeld in einem Bereich zu erzeugen, durch den Fluid fließt, dessen Fluss zu messen ist, und in dem ein gleichmäßiges schwaches Magnetfeld, wie das Magnetfeld der Erde, besteht, und ein elektrischer Strom durch die mindestens eine Spule (40) geführt und plötzlich durch elektrische Schaltungen (46 bis 52), die mit der mindestens einen Spule (40) verbunden sind, abgeschaltet wird, worauf ein NMR-Sensor (42) verwendet wird, um ein Maß des Abklingens des NMR-Signals aus der Präzession von Kernen (60) innerhalb eines solchen Fluids im Anschluss an das plötzliche Abschalten des elektrischen Stroms (48) bereitzustellen, und ein Maß des Flusses eines solchen Fluids aus dem Maß des Abklingens unter Verwenden eines Prozessors (52) der elektrischen Schaltungen bereitgestellt wird, **dadurch gekennzeichnet, dass** die mindestens eine Spule (40) einen Wasserlauf (14) dessen Wasserflusses zu messen ist, umgibt.

8. Verfahren zum Messen des Flusses eines Fluids nach Anspruch 7 unter Verwenden eines Durchflussmessers nach einem der Ansprüche 2 bis 6.

## Revendications

1. Débitmètre à résonance magnétique nucléaire comprenant au moins une bobine (40) de matériau électriquement conducteur à travers laquelle s'écoule un courant électrique lorsque l'appareil est en cours d'utilisation pour générer un champ magnétique dans une région à travers laquelle s'écoule un fluide dont le débit doit être mesuré et dans laquelle il y a un champ magnétique faible uniforme tel que le champ magnétique terrestre, des circuits électriques (46 à 52) connectés à ladite au moins une bobine (40) pour établir et couper brusquement un tel courant électrique, un capteur RMN (42) connecté aux circuits électriques (46 à 52) pour fournir une mesure du déclin dans le signal RMN à partir de noyaux (60) dans un tel fluide à la suite de la coupure brusque d'un tel courant électrique, et un processeur (52) des circuits électriques formé et/ou programmé pour fournir une mesure de débit d'un tel fluide à partir de ladite mesure du déclin, **caractérisé en ce que** ladite au moins une bobine (40) à l'aide de laquelle le champ magnétique est généré est suffisamment grande pour entourer entièrement une rivière (14).

2. Débitmètre à résonance magnétique nucléaire selon la revendication 1, dans lequel ledit courant électrique est un courant continu pour générer un champ magnétique unidirectionnel.

3. Débitmètre à résonance magnétique nucléaire selon la revendication 1, dans lequel ledit courant électrique est un courant pulsé ou alternatif pour générer un champ magnétique pulsé ou alternatif.

4. Débitmètre à résonance magnétique nucléaire selon l'une quelconque des revendications précédentes, dans lequel ledit capteur RMN (42) comprend ladite au moins une bobine (40).

5. Débitmètre à résonance magnétique nucléaire selon l'une quelconque des revendications 1 à 3, dans lequel ledit capteur RMN (42) comprend au moins une autre bobine (42), de telle sorte que le capteur RMN (42) ne comprend pas ladite au moins une bobine (40).

6. Débitmètre à résonance magnétique nucléaire selon la revendication 5, dans lequel ladite au moins une autre bobine (42) est située sensiblement dans la même position que ladite au moins une bobine (40).

7. Procédé de mesure de l'écoulement d'un fluide, dans lequel un courant électrique traverse au moins une bobine de matériau électriquement conducteur pour générer un champ magnétique dans une région à travers laquelle s'écoule un fluide dont le débit doit être mesuré et dans laquelle il y a un champ magnétique faible uniforme tel que le champ magnétique terrestre, et un courant électrique est amené à traverser ladite au moins une bobine (40) et est brusquement coupé par des circuits électriques (46 à 52) connectés à ladite au moins une bobine (40), sur quoi un capteur NMR (42) est utilisé pour fournir une mesure du déclin du signal RMN à partir de noyaux de traitement (60) dans un tel fluide à la suite de la coupure brusque du courant électrique (48), et une mesure du débit d'un tel fluide à partir de ladite mesure du déclin est fournie à l'aide d'un processeur (52) des circuits électriques, **caractérisé en ce que** ladite au moins une bobine (40) entoure une rivière (14) le long de laquelle le débit d'eau doit être mesuré.

8. Procédé de mesure de l'écoulement d'un fluide selon la revendication 7, à l'aide d'un débitmètre selon l'une quelconque des revendications 2 à 6.

III

16

22 — 12

II — 10 — II

14

20

18

III

## Fig. 1

30   32

10 — 18

24 — 26

14   28

## Fig. 2

20  12  22  10

## Fig. 3

Fig. 4

Fig. 5a

Fig. 5b

Fig. 5c

Fig. 5d

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4638251 A
- US 2014009148 A1
- EP 0106472 A
- WO 2009045670 A

**Non-patent literature cited in the description**

- Earth's field NMR flow meter: Preliminary quantitative measurement. **EINAR O et al.** Journal of Magnetic Resonance. Academic Press, 25 June 2014, vol. 245, 110-115